# FASCICULE DE BREVET EUROPEEN

(11) **EP 3 631 476 B1**
(45) Date de publication et mention de la délivrance du brevet: **10.04.2024**
(21) Numéro de dépôt: 18725259.8
(22) Date de dépôt: 25.05.2018
(51) Int. Cl.: G01R 22/06, H01H 83/12, H02H 5/10, G01R 31/08, H02H 3/06, H02H 3/07

(54) **COMPTEUR ELECTRIQUE MONOPHASE**
EINPHASIGER STROMZÄHLER
SINGLE-PHASE ELECTRIC METER

(30) Priorité: 31.05.2017 FR 1754836
(43) Date de publication de la demande: 08.04.2020
(73) Titulaire: Sagemcom Energy & Telecom SAS, 92270 Bois-Colombes (FR)
(72) Inventeur: TEBOULLE, Henri, 92500 Rueil Malmaison (FR)
(74) Mandataire: Cabinet Boettcher
(86) Numéro de dépôt international: PCT/EP2018/063789
(87) Numéro de publication internationale: WO 2018/219811

(56) Documents cités:
- EP-A1- 1 962 098
- WO-A1-2014/053302
- WO-A1-2015/179908
- WO-A2-2007/121053
- DE-A1-102011 089 211
- GB-A- 2 313 201
- RU-C1- 2 498 322
- US-A1- 2014 002 940
- US-A1- 2015 077 891

## Description

L'invention concerne le domaine des compteurs électriques monophasés.

### ARRIERE PLAN DE L'INVENTION

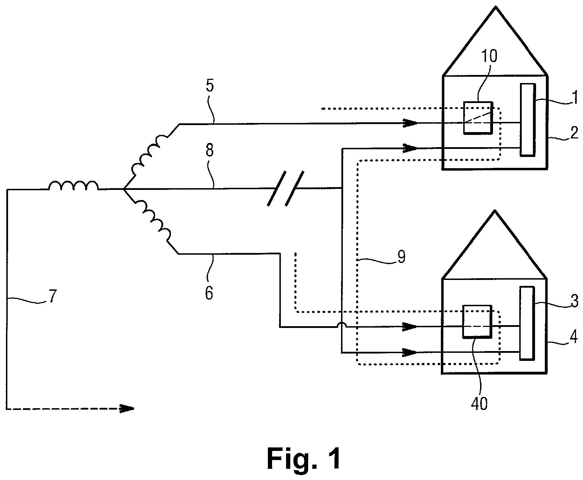

En référence à la figure 1, il est fréquent qu'une première installation électrique 1 d'une première habitation 2 et une deuxième installation électrique 3 d'une deuxième habitation 4 soient reliées respectivement à une première phase 5 et à une deuxième phase 6 d'une même ligne électrique triphasée 7. La première installation électrique 1 et la deuxième installation électrique 3 sont toutes deux reliées au neutre 8 de la ligne électrique triphasée 7. La ligne électrique triphasée 7 achemine vers la première installation électrique 1 et vers la deuxième installation électrique 3 l'énergie électrique que leurs équipements électriques consomment.

En cas de rupture du neutre 8 de la ligne électrique triphasée 7, si la charge de la première installation électrique 1 est sensiblement plus faible que la charge de la deuxième installation électrique 3 (ou inversement), le déséquilibre des charges peut provoquer une baisse de tension importante en entrée de la première installation électrique 1 et une hausse de tension importante en entrée de la deuxième installation électrique 3 (ou inversement). Le courant circule depuis la ligne électrique triphasée 7 via la première installation électrique 1 et la deuxième installation électrique 3 sur la boucle 9.

Une telle situation se produit par exemple lorsqu'un radiateur de la deuxième installation électrique 3 est allumé et que les habitants de la première habitation 2 sont absents.

Si le réseau de distribution intégrant la ligne électrique triphasée 7 est un réseau de tension efficace 230V, la tension en entrée de la première installation électrique 1 peut ainsi diminuer jusqu'à 50V, et la tension en entrée de la deuxième installation électrique 3 peut atteindre 398V, ce qui correspond à une tension normale entre la première phase 5 et la deuxième phase 6.

Certains compteurs électriques sont munis d'un organe de coupure qui permet d'éviter qu'une telle hausse de tension importante ne dégrade les équipements d'une installation électrique. Cependant, tous les compteurs électriques ne sont pas munis d'un tel organe de coupure. Si le compteur électrique (monophasé) de la deuxième installation électrique 3 n'est pas muni d'un organe de coupure, les équipements électriques de la deuxième installation électrique 3 risquent d'être détruits, voire de prendre feu. En effet, si la somme des charges dans la boucle 9 est suffisamment élevée, le courant dans la deuxième installation électrique 3 sera trop faible pour que les fusibles internes des équipements électriques les protègent,

US2015/077891 divulgue un compteur électrique muni d'un organe de coupure avec mesure de tension, l'organe de coupure étant piloté extérieurement.

DE102011089211 divulgue un circuit indépendant de protection d'une installation alimentée sur une ligne monophasée, comportant un organe de coupure, un capteur de tension et des moyens de 1 traitement pour ouvrir l'organe de coupure en cas de sous-tension.

### OBJET DE L'INVENTION

L'invention a pour objet de protéger une installation électrique contre une hausse de tension importante due à une rupture du neutre d'une ligne électrique triphasée et à un déséquilibre de charges, le compteur électrique de ladite installation électrique n'étant pas équipé d'un organe de coupure.

### RESUME DE L'INVENTION

En vue de la réalisation de ce but, on propose un compteur électrique monophasé comportant un conducteur de phase destiné à être relié à une phase d'une ligne électrique située en amont du compteur électrique monophasé et à une phase d'une installation électrique située en aval du compteur électrique monophasé, le compteur électrique monophasé comprenant en outre un organe de coupure monté sur le conducteur de phase, un capteur de tension amont agencé pour mesurer périodiquement une tension amont en amont de l'organe de coupure, et des moyens de traitement agencés pour acquérir des mesures de tension amont et pour ouvrir l'organe de coupure lorsque la tension amont devient inférieure à un premier seuil de tension prédéterminé.

Ainsi, en cas de rupture d'un neutre de la ligne électrique et de déséquilibre des charges, qui génèrent une baisse de tension importante en entrée de l'installation électrique, le compteur électrique monophasé selon l'invention ouvre l'organe de coupure. Une autre installation électrique, connectée au neutre et à une autre phase de la même ligne électrique et comprenant un compteur électrique monophasé non équipé d'un organe de coupure, est ainsi protégée d'une hausse de tension importante grâce au compteur électrique monophasé selon l'invention.

On propose de plus un système comprenant un premier compteur électrique monophasé tel que celui qui vient d'être décrit et un deuxième compteur électrique monophasé, le deuxième compteur électrique monophasé ne comprenant pas d'organe de coupure.

On propose aussi un procédé de surveillance mis en oeuvre dans un compteur électrique monophasé tel que celui qui vient d'être décrit, comportant les étapes :
- de mesurer la tension amont ;
- d'ouvrir l'organe de coupure lorsque la tension amont devient inférieure à un premier seuil de tension prédéterminé

On propose en outre un procédé de protection d'une deuxième installation électrique par un premier compteur électrique monophasé d'une première installation électrique, le premier compteur électrique monophasé étant conforme à celui qui vient d'être décrit, la deuxième installation électrique comportant un deuxième compteur électrique monophasé ne comprenant pas d'organe de coupure, la première installation électrique et la deuxième installation électrique étant connectées respectivement à une première phase et à une deuxième phase d'une même ligne électrique, la première installation électrique et la deuxième installation électrique étant connectées à un neutre de la ligne électrique, le procédé de protection étant mis en oeuvre dans le premier compteur électrique monophasé et comprenant les étapes du procédé de surveillance qui vient d'être décrit.

On propose de plus un programme d'ordinateur comprenant des instructions pour mettre en oeuvre, par un compteur électrique monophasé tel que celui qui vient d'être décrit, le procédé de surveillance ou le procédé de protection qui viennent d'être évoqués.

On propose en outre des moyens de stockage qui stockent un programme d'ordinateur comprenant des instructions pour mettre en oeuvre, par un compteur électrique monophasé tel que celui qui vient d'être décrit, le procédé de surveillance ou le procédé de protection qui viennent d'être évoqués.

D'autres caractéristiques et avantages de l'invention ressortiront à la lecture de la description qui suit d'un mode de réalisation particulier non limitatif de l'invention.

### BREVE DESCRIPTION DES DESSINS

Il sera fait référence aux dessins annexés, parmi lesquels :
- la figure 1 représente une ligne électrique triphasée, une première installation électrique d'une première habitation et une deuxième installation électrique d'une deuxième habitation ;
- la figure 2 représente un compteur électrique monophasé selon l'invention.

### DESCRIPTION DETAILLEE DE L'INVENTION

L'invention est décrite dans le contexte de la figure 1, qui vient d'être présenté.

La première installation électrique 1 de la première habitation 2 et la deuxième installation électrique 3 de la deuxième habitation 4 sont reliées respectivement à la première phase 5 et à la deuxième phase 6 d'une même ligne électrique triphasée 7. La première installation électrique 1 et la deuxième installation électrique 3 sont toutes deux reliées au neutre 8 de la ligne électrique triphasée 7.

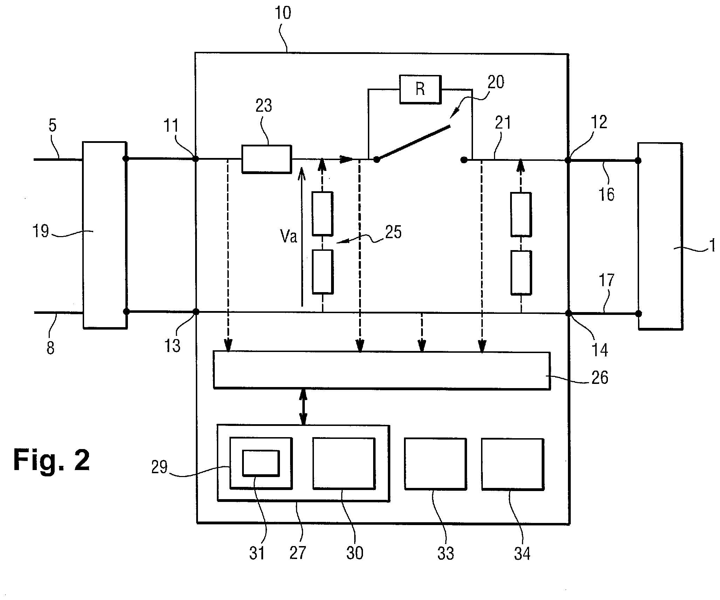

En référence à la figure 2, la première installation électrique 1 comporte un premier compteur électrique monophasé 10.

Le premier compteur 10 est destiné à mesurer une consommation d'énergie électrique fournie à la première installation électrique 1 via la ligne électrique triphasée 7.

Le premier compteur 10 comporte une borne de phase amont 11, une borne de phase aval 12, une borne de neutre amont 13 et une borne de neutre aval 14.

La borne de phase amont 11 est connectée à la première phase 5 de la ligne électrique triphasée 7. La borne de phase aval 12 est connectée à une phase 16 de la première installation électrique 1. La borne de neutre amont 13 est connectée au neutre 8 de la ligne électrique triphasée 7. La borne de neutre aval 14 est connectée à un neutre 17 de la première installation électrique 1.

Un sectionneur 19 est positionné du côté de la ligne électrique triphasée 7, pour pouvoir isoler de la ligne électrique triphasée 7 la première installation électrique 1.

Le premier compteur 10 comporte de plus un organe de coupure 20 monté sur un conducteur de phase 21 du premier compteur 10. Le conducteur de phase 21 est relié à la première phase 5 de la ligne électrique triphasée 7 et à la phase 16 de la première installation électrique 1 lorsque le premier compteur 10 est raccordé à la ligne électrique triphasée 7 et à la première installation électrique 1. L'organe de coupure 20 est monté entre la borne de phase amont 11 et la borne de phase aval 12.

L'organe de coupure 20 permet de sélectivement connecter et déconnecter, à distance, la première installation électrique 1 de la ligne électrique triphasée 7.

Le premier compteur 10 comporte de plus un capteur de tension amont 25 adapté à mesurer une tension amont Va en amont de l'organe de coupure 20, c'est à dire du côté de la ligne électrique triphasée 7 par rapport à l'organe de coupure 20. Le capteur de tension amont 25 est symbolisé par deux résistances, mais il est en réalité possiblement plus complexe.

Le premier compteur 10 comporte aussi un capteur de courant 23 situé sur le conducteur de phase 21 en amont de l'organe de coupure 20, et destiné à mesurer un courant circulant dans le conducteur de phase 21. Le capteur de courant 23 est ici un *shunt.*

Le compteur 10 comporte en outre une pluralité de composants électriques regroupés en un bloc fonctionnel de métrologie 26 et en un bloc fonctionnel d'application 27. Le bloc fonctionnel de métrologie 26 et le bloc fonctionnel d'application 27 sont séparés et indépendants, de sorte qu'une panne de l'un des blocs n'entraîne pas une panne de l'autre bloc.

Le bloc fonctionnel de métrologie 26 acquiert les mesures de tension amont Va et les transmet au bloc fonctionnel d'application 27.

Le bloc fonctionnel d'application 27 comporte des moyens de traitement 29 et une mémoire 30.

Les moyens de traitement 29 comportent un composant de traitement 31 (par exemple un processeur, un microcontrôleur ou un FPGA). Le composant de traitement 31 est adapté à exécuter des instructions d'un programme pour mettre en oeuvre un procédé de surveillance et un procédé de protection de la deuxième installation électrique 3 par le premier compteur 10. Le composant de traitement 31 est notamment adapté à gérer le fonctionnement du premier compteur 10, à ouvrir et à refermer l'organe de coupure 20 via un dispositif d'ouverture, à acquérir et à traiter les mesures de tension amont Va. Le dispositif d'ouverture est intégré dans le premier compteur 10.

La mémoire 30 est une mémoire non volatile susceptible de stocker des données auxquelles le composant de traitement 31 a accès.

Le premier compteur 10 comporte de plus un module de communication 33 par courants porteurs en ligne qui est agencé pour transmettre des messages sur la ligne électrique triphasée 7. Le module de communication 33 est alimenté directement par la ligne électrique triphasée 7.

Le premier compteur 10 comporte enfin un composant de stockage d'énergie 34 adapté à alimenter le module de communication 33 pendant une certaine durée lorsque l'organe de coupure 20 est ouvert. En effet, dans le cas où l'organe de coupure 20 est ouvert, le module de communication 33 ne peut plus être plus alimenté par la ligne électrique triphasée 7.

La deuxième installation électrique 3 comprend quant à elle un deuxième compteur électrique monophasé 40, qui ne comporte pas d'organe de coupure.

Ainsi, en cas de rupture du neutre 8 de la ligne électrique triphasée 7, si la charge de la première installation électrique 1 est sensiblement plus faible que la charge de la deuxième installation électrique 3, la deuxième installation électrique 3 n'est pas protégée efficacement contre une hausse de tension importante en entrée de la deuxième installation électrique 3. C'est le premier compteur 10 qui protège la deuxième installation électrique 3 dans une telle situation.

Pour cela, lorsque le composant de traitement 31 du premier compteur 10 détecte que la tension amont Va dans le premier compteur 10 devient inférieure à un premier seuil de tension prédéterminé, le composant de traitement 31 ouvre l'organe de coupure 20 du premier compteur 10. Ainsi, le déséquilibre des charges n'a plus de conséquence sur la tension en entrée de la deuxième installation électrique 3. La deuxième installation électrique 3 ne subit donc plus la hausse de tension importante.

Le premier seuil de tension prédéterminé est ici égal à 160V.

Le capteur de tension amont 25 mesure périodiquement la tension amont Va, avec une période ici égale à 100ms. Cette période réduite, et donc la fréquence importante des mesures de tension amont Va, permettent d'assurer une ouverture rapide de l'organe de coupure 20 en cas de rupture du neutre 8.

L'ouverture de l'organe de coupure 20 est réalisée seulement si la baisse de tension importante en entrée de la première installation électrique 1 a été rapide.

On assure ainsi que la situation qui génère la baisse de tension importante en entrée de la première installation électrique 1 et la hausse de tension importante en entrée de la deuxième installation électrique 3 correspond bien à une rupture du neutre 8 de la ligne électrique triphasée 7.

Le composant de traitement 31 ouvre donc l'organe de coupure 20 uniquement lorsque la tension amont Va passe d'une valeur normale à une valeur inférieure au premier seuil de tension prédéterminé en un temps inférieur à une durée prédéterminée. La valeur normale est ici une tension efficace de 230V.

La durée prédéterminée est égale à quelques secondes, et est ici comprise entre 1 seconde et 10 secondes.

Lorsque le composant de traitement 31 détecte que la tension amont Va devient supérieure à un deuxième seuil de tension prédéterminé, le composant de traitement 31 referme l'organe de coupure 20. Cette situation correspond à une réparation du neutre 8 de la ligne électrique triphasée 7 et à un retour à la valeur normale de la tension amont Va (et donc de la tension en entrée de la première installation électrique 1).

Le deuxième seuil de tension prédéterminé est ici égal à 180V.

Le composant de traitement 31 referme l'organe de coupure 20 après une durée aléatoire à compter d'un moment où le composant de traitement 31 a détecté que la tension amont Va devient supérieure au deuxième seuil de tension prédéterminé. La durée aléatoire est ici comprise entre 10 secondes et 2 minutes. Cette temporisation aléatoire permet d'éviter que plusieurs habitations équipées de compteurs semblables au premier compteur 10 ne redémarrent simultanément, et donc qu'une installation électrique de l'une de ces habitations ne subisse à son tour une hausse de tension importante.

La durée aléatoire est augmentée automatiquement (tout en demeurant aléatoire) après que le composant de traitement 31 ait refermé deux fois l'organe de coupure 20 à cause d'une tension amont Va inférieure au premier seuil de tension prédéterminé, c'est à dire après deux réamorçages de l'organe de coupure 20 suivant la détection d'une rupture du neutre 8.

Après les deux fermetures de l'organe de coupure 20, la durée aléatoire est ensuite augmentée après chaque nouvelle fermeture due à une tension amont Va inférieure au premier seuil de tension prédéterminé.

On évite ainsi de redémarrer la première installation électrique 1 alors qu'un défaut subsiste sur le neutre 8 de la ligne électrique triphasée 7. Une désactivation de longue durée de la première installation électrique 1 indique qu'il convient désormais obligatoirement de réparer le neutre 8.

Lorsque le composant de traitement 31 détecte une baisse de tension en entrée de la première installation électrique 1, le composant de traitement 31 commande le module de communication 33 pour que celui-ci génère un message d'alarme à destination du Système d'Information (SI). Le message d'alarme prévient le SI de la rupture du neutre 8 de la ligne électrique triphasée 7.

Le message d'alarme est transmis par courants porteurs en ligne entre la phase 5 et le neutre 8 de la ligne électrique triphasée 7. Les couches applicatives DLMS ou COSEM sont avantageusement utilisées.

Le composant de stockage 34 est dimensionné pour alimenter le dispositif d'ouverture de l'organe de coupure 20 et le module de communication 33 pendant une durée de transmission du message d'alarme en cas de baisse de tension ne permettant plus d'alimenter le premier compteur 10. Le composant de stockage 34 comprend par exemple des capacités chimiques de l'ordre de 100uF connectées à une tension d'alimentation du premier compteur 10.

Bien entendu, l'invention n'est pas limitée au mode de réalisation décrit mais englobe toute variante entrant dans le champ de l'invention telle que définie par les revendications.

Bien que l'on ait décrit une architecture particulière du compteur électrique monophasé, celle-ci pourrait bien sûr être différente. Les composants électriques utilisés pourraient eux aussi être différents.

On note que, bien que l'on ait uniquement évoqué une première installation électrique et une deuxième installation électrique, il est possible et même probable que plusieurs installations électriques soient connectées à la première phase de la ligne électrique triphasée, et que plusieurs installations électriques soient connectées à la deuxième phase de la ligne électrique triphasée.

L'invention s'applique par ailleurs à tout type de ligne électrique comprenant un neutre et au moins deux phases.

## Revendications

1. Compteur électrique monophasé (10) comportant un conducteur de phase (21) destiné à être relié à une phase (5) d'une ligne électrique (7) située en amont du compteur électrique monophasé et à une phase (16) d'une installation électrique (1) située en aval du compteur électrique monophasé, le compteur électrique monophasé (10) comprenant en outre un organe de coupure (20) monté sur le conducteur de phase (21), un capteur de tension amont (25) agencé pour mesurer périodiquement une tension amont (Va) en amont de l'organe de coupure (20), et des moyens de traitement (29) agencés pour acquérir des mesures de tension amont et pour ouvrir l'organe de coupure (20) lorsque la tension amont (Va) devient inférieure à un premier seuil de tension prédéterminé.

2. Compteur électrique monophasé selon la revendication 1, dans lequel les moyens de traitement (29) sont agencés pour ouvrir l'organe de coupure (20) lorsque la tension amont (Va) passe d'une valeur normale à une valeur inférieure au premier seuil de tension prédéterminé en un temps inférieur à une durée prédéterminée.

3. Compteur électrique monophasé selon la revendication 1, dans lequel les moyens de traitement (29) sont agencés pour refermer l'organe de coupure (20) lorsque la tension amont (Va) devient supérieure à un deuxième seuil de tension prédéterminé.

4. Compteur électrique monophasé selon la revendication 3, dans lequel les moyens de traitement (29) sont agencés pour refermer l'organe de coupure (20) après une durée aléatoire à compter d'un moment où les moyens de traitement (29) détectent que la tension amont (Va) devient supérieure au deuxième seuil de tension prédéterminé.

5. Compteur électrique monophasé selon la revendication 4, les moyens de traitement étant agencés de sorte que la durée aléatoire est augmentée après que les moyens de traitement (29) aient refermé deux fois l'organe de coupure à cause d'une tension amont (Va) inférieure au premier seuil de tension prédéterminé.

6. Compteur électrique monophasé selon la revendication 5, dans lequel les moyens de traitement sont agencés de sorte que, après deux fermetures de l'organe de coupure (20), la durée aléatoire est augmentée après chaque nouvelle fermeture due à une tension amont (Va) inférieure au premier seuil de tension prédéterminé.

7. Compteur électrique monophasé selon la revendication 1, comprenant en outre un module de communication (33) par courants porteurs en ligne, qui est agencé pour transmettre un message d'alarme sur la ligne électrique (7) lorsque la tension amont (Va) devient inférieure au premier seuil de tension prédéterminé.

8. Compteur électrique monophasé selon la revendication 7, comprenant en outre un dispositif d'ouverture de l'organe de coupure (20) et un composant de stockage d'énergie (34) adapté à alimenter le dispositif d'ouverture de l'organe de coupure (20) et le module de communication (33) pendant une durée de transmission du message d'alarme en cas de baisse de tension ne permettant plus d'alimenter le compteur électrique monophasé.

9. Système comprenant un premier compteur électrique monophasé (10) selon l'une des revendications précédentes et un deuxième compteur électrique monophasé (40), le deuxième compteur électrique monophasé (40) ne comprenant pas d'organe de coupure.

10. Procédé de surveillance mis en oeuvre dans un compteur électrique monophasé (10) selon l'une des revendications 1 à 8, comportant les étapes :
- de mesurer la tension amont (Va) ;
- d'ouvrir l'organe de coupure (20) lorsque la tension amont (Va) devient inférieure à un premier seuil de tension prédéterminé.

11. Procédé de surveillance selon la revendication 10, comportant de plus l'étape de refermer l'organe de coupure (20) lorsque la tension amont (Va) devient supérieure à un deuxième seuil de tension prédéterminé.

12. Procédé de protection d'une deuxième installation électrique (3) par un premier compteur électrique monophasé (10) d'une première installation électrique (1), le premier compteur électrique monophasé (10) étant conforme à l'une des revendication 1 à 8, la deuxième installation électrique (3) comportant un deuxième compteur électrique monophasé (40) ne comprenant pas d'organe de coupure, la première installation électrique (1) et la deuxième installation électrique (3) étant connectées respectivement à une première phase (5) et à une deuxième phase (6) d'une même ligne électrique (7), la première installation électrique et la deuxième installation électrique étant connectées à un neutre (8) de la ligne électrique (7), le procédé de protection étant mis en oeuvre dans le premier compteur électrique monophasé (10) et comprenant les étapes du procédé de surveillance selon la revendication 10.

13. Programme d'ordinateur comprenant des instructions pour mettre en oeuvre, par un compteur électrique monophasé selon la revendication 1, le procédé de surveillance ou le procédé de protection selon l'une des revendications 10 à 12.

14. Moyens de stockage, **caractérisés en ce qu'**ils stockent un programme d'ordinateur comprenant des instructions pour mettre en oeuvre, par un compteur électrique monophasé selon la revendication 1, le procédé de surveillance ou le procédé de protection selon l'une des revendications 10 à 12.

## Patentansprüche

1. Einphasiger Stromzähler (10), umfassend einen Phasenleiter (21), der dazu bestimmt ist, mit einer Phase (5) einer elektrischen Leitung (7) verbunden zu werden, die sich stromaufwärts des einphasigen Stromzählers befindet, sowie mit einer Phase (16) einer elektrischen Anlage (1), die sich stromabwärts des einphasigen Stromzählers befindet, wobei der einphasige Stromzähler (10) ferner ein Schaltelement (20) umfasst, das auf dem Phasenleiter (21) montiert ist, einen stromaufwärtigen Spannungssensor (25), der ausgebildet ist, periodisch eine stromaufwärtige Spannung (Va) stromaufwärts des Schaltelements (20) zu messen, und Verarbeitungsmittel (29), die ausgebildet sind, stromaufwärtige Spannungsmessungen zu erfassen und das Schaltelement (20) zu öffnen, wenn die stromaufwärtige Spannung (Va) niedriger als ein erster vorbestimmter Spannungsschwellenwert wird.

2. Einphasiger Stromzähler nach Anspruch 1, bei dem die Verarbeitungsmittel (29) ausgebildet sind, das Schaltelement (20) zu öffnen, wenn die stromaufwärtige Spannung (Va) von einem normalen Wert auf einen Wert übergeht, der niedriger als der erste vorbestimmte Spanungsschwellenwert ist, in einer Zeit, die kürzer als eine vorbestimmte Dauer ist.

3. Einphasiger Stromzähler nach Anspruch 1, bei dem die Verarbeitungsmittel (29) ausgebildet sind, das Schaltelement (20) erneut zu schließen, wenn die stromaufwärtige Spannung (Va) höher als ein zweiter vorbestimmter Spannungsschwellenwert wird.

4. Einphasiger Stromzähler nach Anspruch 3, bei dem die Verarbeitungsmittel (29) ausgebildet sind, das Schaltelement (20) nach einer zufälligen Dauer ab einem Zeitpunkt, zu dem die Verarbeitungsmittel (29) erfassen, dass die stromaufwärtige Spannung (Va) höher als der zweite vorbestimmte Spannungsschwellenwert wird, erneut zu schließen.

5. Einphasiger Stromzähler nach Anspruch 4, wobei die Verarbeitungsmittel derart ausgebildet sind, dass die zufällige Dauer erhöht wird, nachdem die Verarbeitungsmittel (29) das Schaltelement aufgrund einer stromaufwärtigen Spannung (Va), die niedriger als der erste vorbestimmte Spannungsschwellenwert ist, zweimal erneut geschlossen haben.

6. Einphasiger Stromzähler nach Anspruch 5, bei dem die Verarbeitungsmittel derart ausgebildet sind, dass nach zwei Schließungen des Schaltelements (20) die zufällige Dauer nach jedem neuen Schließen aufgrund einer stromaufwärtigen Spannung (Va), die niedriger als der erste vorbestimmte Spannungsschwellenwert ist, erhöht wird.

7. Einphasiger Stromzähler nach Anspruch 1, ferner umfassend ein Powerline-Kommunikationsmodul (33), das ausgebildet ist, eine Alarmnachricht auf der elektrischen Leitung (7) zu übertragen, wenn die stromaufwärtige Spannung (Va) niedriger als ein erster vorbestimmter Spannungsschwellenwert wird.

8. Einphasiger Stromzähler nach Anspruch 7, ferner umfassend eine Vorrichtung zum Öffnen des Schaltelements (20) und eine Energiespeicherkomponente (34), die geeignet ist, die Vorrichtung zum Öffnen des Schaltelements (20) und das Kommunikationsmodul (33) für eine Übertragungsdauer der Alarmnachricht im Falle eines Spannungsabfalls, der ein Versorgen des einphasigen Stromzählers nicht mehr ermöglicht, zu versorgen.

9. System, umfassend einen ersten einphasigen Stromzähler (10) nach einem der vorhergehenden Ansprüche und einen zweiten einphasigen Stromzähler (40), wobei der zweite einphasige Stromzähler (40) kein Schaltelement umfasst.

10. Überwachungsverfahren, das in einem einphasigen Stromzähler (10) nach einem der Ansprüche 1 bis 8 durchgeführt wird, umfassend die Schritte:
- Messen der stromaufwärtigen Spannung (Va);
- Öffnen des Schaltelements (20), wenn die stromaufwärtige Spannung (Va) niedriger als ein erster vorbestimmter Spannungsschwellenwert wird.

11. Überwachungsverfahren nach Anspruch 10, ferner umfassend den Schritt des erneuten Schließens des Schaltelements (20), wenn die stromaufwärtige Spannung (Va) höher als ein zweiter vorbestimmter Spannungsschwellenwert wird.

12. Verfahren zum Schutz einer zweiten elektrischen Anlage (3) durch einen ersten einphasigen Stromzähler (10) einer ersten elektrischen Anlage (1), wobei der erste einphasige Stromzähler (10) gemäß einem der Ansprüche 1 bis 8 ausgebildet ist, wobei die zweite elektrische Anlage (3) einen zweiten einphasigen Stromzähler (40) umfasst, der kein Schaltelement umfasst, wobei die erste elektrische Anlage (1) und die zweite elektrische Anlage (3) mit einer ersten Phase (5) bzw. einer zweiten Phase (6) einer selben elektrischen Leitung (7) verbunden sind, wobei die erste elektrische Anlage und die zweite elektrische Anlage mit einem Neutralleiter (8) der elektrischen Leitung (7) verbunden sind, wobei das Schutzverfahren in dem ersten einphasigen Stromzähler (10) durchgeführt wird und die Schritte des Überwachungsverfahrens nach Anspruch 10 umfasst.

13. Computerprogramm, umfassend Anweisungen zum Durchführen des Überwachungsverfahrens oder des Schutzverfahrens nach einem der Ansprüche 10 bis 12 mittels eines einphasigen Stromzählers nach Anspruch 1.

14. Speichermittel, **dadurch gekennzeichnet, dass** sie ein Computerprogramm speichern, das Anweisungen zum Durchführen des Überwachungsverfahrens oder des Schutzverfahrens nach einem der Ansprüche 10 bis 12 mittels eines einphasigen Stromzählers nach Anspruch 1 umfasst.

## Claims

1. Single-phase electricity meter (10) including a phase conductor (21) that is intended to be connected to one phase (5) of an electrical line (7) that is located upstream of the single-phase electricity meter and to one phase (16) of an electrical setup (1) that is located downstream of the single-phase electricity meter, the single-phase electricity meter (10) further comprising a switching member (20) that is fitted to the phase conductor (21), an upstream voltage sensor (25) that is arranged to periodically measure an upstream voltage (Va) upstream of the switching member (20), and processing means (29) that are arranged to acquire upstream voltage measurements and to open the switching member (20) when the upstream voltage (Va) falls below a first predetermined threshold voltage.

2. Single-phase electricity meter according to Claim 1, wherein the processing means (29) are arranged to open the switching member (20) when the upstream voltage (Va) transitions from a normal value to a value that is lower than the first predetermined threshold voltage in a time that is shorter than a predetermined duration.

3. Single-phase electricity meter according to Claim 1, wherein the processing means (29) are arranged to close the switching member (20) when the upstream voltage (Va) rises above a second predetermined threshold voltage.

4. Single-phase electricity meter according to Claim 3, wherein the processing means (29) are arranged to close the switching member (20) after a random duration starting from when the processing means (29) detect that the upstream voltage (Va) has risen above the second predetermined threshold voltage.

5. Single-phase electricity meter according to Claim 4, the processing means being arranged such that the random duration is increased after the processing means (29) have closed the switching member twice because of an upstream voltage (Va) that is lower than the first predetermined threshold voltage.

6. Single-phase electricity meter according to Claim 5, wherein the processing means are arranged such that, after two closures of the switching member (20), the random duration is increased after each new closure due to an upstream voltage (Va) lower than the first predetermined threshold voltage.

7. Single-phase electricity meter according to Claim 1, further comprising a powerline communication module (33) that is arranged to transmit a warning message over the electrical line (7) when the upstream voltage (Va) falls below the first predetermined threshold voltage.

8. Single-phase electricity meter according to Claim 7, further comprising a device for opening the switching member (20) and an energy storage component (34) that is suitable for supplying power to the device for opening the switching member (20) and the communication module (33) for a duration of transmission of the warning message in the event of a voltage drop no longer allowing the single-phase electricity meter to be supplied with power.

9. System comprising a first single-phase electricity meter (10) according to one of the preceding claims and a second single-phase electricity meter (40), the second single-phase electricity meter (40) not comprising a switching member.

10. Monitoring method implemented in a single-phase electricity meter (10) according to one of Claims 1 to 8, including the steps of:
- measuring the upstream voltage (Va);
- opening the switching member (20) when the upstream voltage (Va) falls below a first predetermined threshold voltage.

11. Monitoring method according to Claim 10, further including the step of closing the switching member (20) when the upstream voltage (Va) rises above a second predetermined threshold voltage.

12. Method for protecting a second electrical setup (3) by means of a first single-phase electricity meter (10) of a first electrical setup (1), the first single-phase electricity meter (10) being in accordance with one of Claims 1 to 8, the second electrical setup (3) including a second single-phase electricity meter (40) comprising no switching member, the first electrical setup (1) and the second electrical setup (3) being connected, respectively, to a first phase (5) and to a second phase (6) of one and the same electrical line (7), the first electrical setup and the second electrical setup being connected to a neutral (8) of the electrical line (7), the protection method being implemented in the first single-phase electricity meter (10) and comprising the steps of the monitoring method according to Claim 10.

13. Computer program comprising instructions for implementing, by a single-phase electricity meter according to Claim 1, the monitoring method or the protection method according to one of Claims 10 to 12.

14. Storage means, **characterized in that** they store a computer program comprising instructions for implementing, by a single-phase electricity meter according to Claim 1, the monitoring method or the protection method according to one of Claims 10 to 12.
